# EUROPÄISCHE PATENTANMELDUNG

(11) **EP 0 632 490 A2**
(43) Veröffentlichungstag der Anmeldung: **04.01.1995**
(21) Anmeldenummer: 94109101.9
(22) Anmeldetag: 14.06.1994
(51) Int. Cl.: H01L 21/331, H01L 29/735

(54) **Herstellungsverfahren für lateralen Bipolartransistor**

(30) Priorität: 02.07.1993 DE 4322137
(71) Anmelder: SIEMENS AKTIENGESELLSCHAFT, D-80333 München (DE)
(72) Erfinder: Bertagnolli, Emmerich, Dr., D-80799 München (DE)

(57) **Zusammenfassung**

Herstellungsverfahren für laterale Bipolartransistoren, bei dem in der mit einer Grunddotierung versehenen Siliziumschicht eines SOI-Substrates unter Verwendung einer Maske eine hoch dotierte Kollektorzone (8) hergestellt wird, dann eine mindestens diese Kollektorzone (8) bedeckende strukturierte Dielektrikumschicht (10) aufgebracht wird, die den für Emitter und Basis vorgesehenen Bereich frei läßt, dieser frei gelassene Bereich umdotiert wird, dann ganzflächig mit gleichmäßiger Dicke (d1) eine Hilfsschicht (11) aufgebracht wird, unter Verwendung dieser Hilfsschicht (11) als Abschirmung für die herzustellende Basiszone (9) eine Dotierung für eine Emitterzone (7) eingebracht wird und anschließend Emitter, Basis und Kollektor mit Kontakten versehen werden.

## Beschreibung

Integrierte Bipolartransistoren werden derzeit hauptsächlich in Form vertikaler Transistoren mit übereinander angeordneten npn-Schichten oder pnp-Schichten gebaut. Bei dieser Vertikalbauweise sind jeweils zwei Schichten dieser Schichtenfolge nicht direkt, d. h. von der Oberfläche her, zugänglich, sondern müssen seitlich verlängert und anschließend an die Oberfläche geführt werden. Für die unterste dotierte Schicht ist im allgemeinen noch eine weitere, hoch dotierte Schicht notwendig, um die Zuleitung zur Oberfläche ausreichend niederohmig zu halten. Der Nachteil dieser Anordnung ist, daß vertikale Transistoren eine merklich Tiefenausdehnung, typischerweise 1 bis 2 µm, und laterale Abmessungen haben, die den eigentlichen vom Transistor beanspruchten Bereich um ein Vielfaches übertreffen. Entsprechend gibt es eine Reihe von parasitären Kapazitäten und Widerständen, die neben einer möglichen Einbuße bei der Schaltgeschwindigkeit vor allem den Leistungsbedarf deutlich erhohen. Darüber hinaus ist die Komplexität des Herstellungsprozesses und der Flächenbedarf dieser Bauelemente verglichen mit MOS-Bauelementen sehr hoch und führt zu niedrigen Ausbeuten und höherem Herstellungsaufwand. Die gleichzeitige Herstellung komplementärer Strukturen (npn- und pnp-Transistoren) z. B. für analoge Anwendungen ist nur unter erheblichem Aufwand möglich. Eine laterale Anordnung eines Bipolartransistors wird üblicherweise so hergestellt, daß in einem auch vertikal relativ weit ausgedehnten und für den Leitungstyp der Basis dotierten Bereich durch lokal begrenztes Umdotieren Zonen für Emitter und Kollektor hergestellt werden.

Aufgabe der vorliegenden Erfindung ist es, ein Verfahren für die vereinfachte Herstellung von im Aufbau verbesserten lateralen Biplartransistoren anzugeben.

Diese Aufgabe wird mit dem Verfahren mit den Schritten des Anspruches 1 gelöst. Weitere Ausgestaltungen ergeben sich aus den abhängigen Ansprüchen.

Bei dem erfindungsgemäßen Verfahren werden die für Emitter, Basis und Kollektor vorgesehenen Zonen in einer dünnen Siliziumschicht, z. B. eines SOI-Substrates, hergestellt. Dadurch ergeben sich eine relativ geringe vertikale Ausdehnung und ein vereinfachtes Herstellungsverfahren. Die geringen Abmessungen insbesondere der Basiszone werden durch die Verwendung einer Dielektrikumschicht mit vertikalem, als Maskierung wirkendem Anteil erreicht.

Es folgt eine Beschreibung des erfindungsgemäßen Verfahrens anhand der Figuren 1 bis 9.
- Fig. 1 bis 3: zeigen einen lateralen Bipolartransistor im Querschnitt nach verschiedenen Schritten des Herstellungsverfahrens.
- Fig. 4: zeigt eine alternative Ausführungsform.
- Fig. 5: zeigt einen erfindungsgemäß hergestellten Transistor in dem in Fig. 6 eingezeichneten Schnitt.
- Fig. 6 bis 9: zeigen jeweils alternative Ausführungsformen des erfindungsgemäß hergestellten fertigen Transistors im Querschnitt.

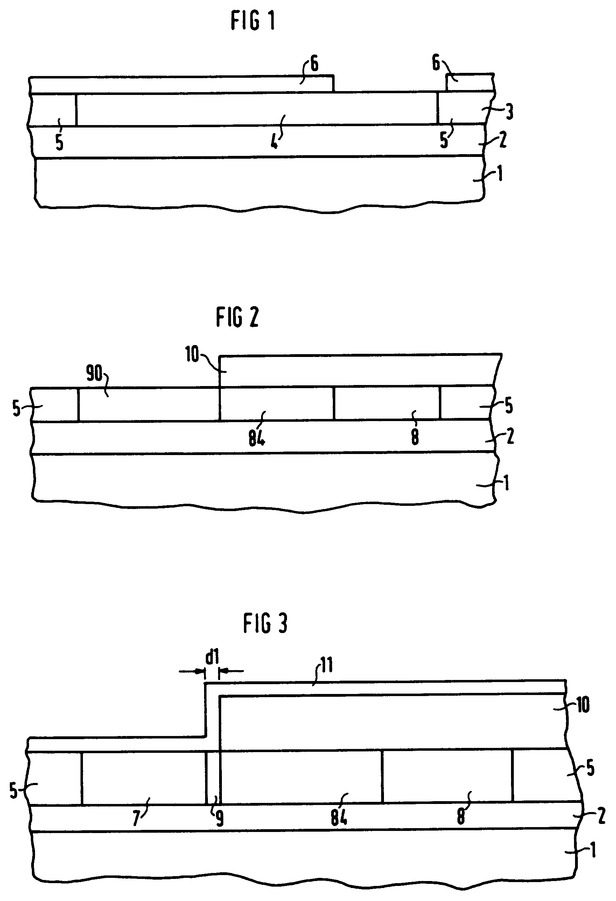

Das erfindungsgemäße Verfahren geht aus von einer Siliziumschicht auf einem isolierenden Untergrund oder einer isolierenden Zwischenschicht. Es kann sich z. B. um die Siliziumschicht eines SOI-Substrates handeln. Es spielt aber für das Verfahren keine Rolle, ob mittels Waferbonding hergestelltes Material oder SIMOX-Material oder irgend ein anderes Material, das eine Siliziumnutzschicht auf einer Isolatorschicht besitzt, als Ausgangsmaterial verwendet wird. In der Siliziumschicht kann erfindungsgemäß eine npn- oder eine pnp-Transistorstruktur hergestellt werden oder z. B. eine der folgenden Dotiersequenzen:
n⁺pn⁻n⁺ (Standardabfolge), n⁺npn⁻n⁺ (n-Pufferschicht zwischen Basis und Emitter zur Reduzierung von Durchbruch, Leckraten und Kapazitäten), n⁺npn⁻nn⁺ (n⁻-Pufferschicht zwischen Basis und Kollektor). In dem Ausführungsbeispiel der Fig. 1 sind auf einem Substrat 1 (z. B. Silizium) eine Isolationsschicht 2 und eine Siliziumschicht 3 ganzflächig vorhanden. Die Dicke der Siliziumschicht 3 kann zwischen 20 nm und 2 µm betragen, die Dotierungshöhe dieser Schicht zwischen 10¹⁵ cm⁻³ und 10¹⁸ cm⁻³ liegen, wobei je nach Transistortyp Donatoren oder Akzeptoren zugesetzt werden. Bei dem in den Figuren dargestellten Ausführungsbeispiel werden zunächst unter Zuhilfenahme einer Fototechnik die Bereiche der Siliziumschicht 3, die für die späteren Transistorbereiche vorgesehen sind, festgelegt. Die Siliziumschicht 3 wird mit einer Grunddotierung versehen und die außerhalb des für den Transistor vorgesehenen Bereiches befindlichen Anteile dieser Siliziumschicht 3 isolierend gemacht. Diese Isolationsbereiche 5 sind in Fig. 1 im Querschnitt seitlich zu dem Bereich 4, in dem die Grunddotierung verbleibt, eingezeichnet. Im Prinzip ist es auch möglich, zunächst die Isolationsbereiche 5 herzustellen und anschließend die Grunddotierung in den dazwischen befindlichen Bereich der Siliziumschicht 3 einzubringen. Die Isolation kann mittels LOCOS erfolgen, bei dem die Gebiete außerhalb der für den Transistor vorgesehenen Bereiche oxidiert werden. Statt dessen kann ein Graben rings um das für den Transistor vorgesehene Gebiet geätzt werden. Es kann auch eine Kombination von LOCOS und Grabenätzung verwendet werden. Das Oxid bildet dann die sogenannte Feldisolation, und ein bis zur Isolationsschicht 2 reichender Graben bildet die vollständige dielektrische Isolation des Transistors nach außen. Denkbar ist auch, daß die Siliziumbereiche außerhalb der Transistorgebiete einfach vollständig weggeätzt werden und die Transistoren damit als Mesas auf der Isolationsschicht 2 stehen bleiben. In den Figuren ist beispielhaft ein Ausführungsbeispiel mit durch LOCOS hergestellten Isolationsbereichen 5 beschrieben. Nach Herstellung der Isolationsbereiche 5 wird zunächst die Kollektorzone durch eine fotolithographisch erzeugte Maske 6 festgelegt und durch Implantation von Dotierstoff hergestellt (z. B. As oder P im Fall einer n-leitenden Dotierung). Ggf. wird das implantierte Gebiet anschließend einem Ausheilungs- und/oder Diffusionsprozeß unterzogen (z. B. RTA/FA-Prozesse). Es wird die Basisanschlußzone ebenfalls fotolithographisch durch eine Maske definiert und durch Implantation von Dotierstoff (z. B. B im Fall von p-leitender Dotierung) hergestellt. Ggf. erfolgt auch an dieser Stelle ein Ausheilungs- und/oder Diffusionsschritt. Bei dem erfindungsgemäßen Verfahren kann die Reihenfolge der Herstellung von Kollektorzone und Basisanschlußzone vertauscht werden.

Danach wird eine Dielektrikumschicht z. B. der Dicke 400 nm abgeschieden. Diese Dielektrikumschicht wird anschließend durch eine Kombination von Fotolithographie und Ätzung so strukturiert, daß sie die Kollektorzone in einer vorgesehenen Weite überlappt. Dadurch wird angrenzend an die Kollektorzone eine weitere Kollektorzone abgedeckt. In Fig. 2 ist die Dielektrikumschicht 10 auf der Kollektorzone 8 und der weiteren Kollektorzone 84 eingezeichnet. Diese mit der Grunddotierung versehene weitere Kollektorzone 84 bildet den aktiven Kollektor, wahrend die Kollektorzone 8 für die Kontaktierung hoch dotiert ist. Typische Werte für die Grunddotierung und damit für die Höhe der Dotierung dieser weiteren Kollektorschicht 84 liegen im Bereiche zwischen 2 x 10¹⁶ cm⁻³ und 5 x 10¹⁷ cm⁻³. Durch die Bemessung des aktiven Kollektors werden wichtige Parameter des Transistors vorbestimmt.

In den von der Dielektrikumschicht 10 freigelassenen Bereich wird eine Implantation eingebracht für die Dotierung der herzustellenden Basiszone. Alternativ zu den beschriebenen Verfahrensschritten ist es möglich, die Basisanschlußzone erst in diesem Schritt zusammen mit der Basiszone herzustellen. Die Dosis dieser Implantation für die Basiszone wird so eingestellt, daß die Dotierung im von der Dielektrikumschicht 10 nicht bedeckten Bereich Werte zwischen 10¹⁷ cm⁻³ und 10¹⁹ cm⁻³ erreicht. Typischerweise wird als Höhe der Dotierung 1 x 10¹⁸ bis 5 x 10¹⁸ cm⁻³ gewählt. Ggf. erfolgt unmittelbar nach der Implantation ein Ausheilungs- und/oder Diffusionsschritt (z. B. 10 Sekunden bei 1000 °C). Es ergibt sich so die in Fig. 2 eingezeichnete Emitter-Basis-Zone 90 mit der für die Basiszone vorgesehenen Dotierung.

Als erfindungswesentlicher Schritt wird im folgenden entsprechend Fig. 3 eine Hilfsschicht 11 der Dicke d1 ganzflächig konform aufgebracht (z. B. durch ein CVD-Verfahren). Diese Dicke d1 wird so groß gewählt, wie die Basisweite des zukünftigen Transistors (d. h. die Abmessung der Basiszone 9 in Richtung von Emitter zu Kollektor) in Anbetracht technischer Toleranzen eingestellt werden soll. Diese Hilfsschicht 11 ist vorteilhaft z. B. TEOS (Tetraethylorthosilan), das mittels CVD bei etwa 700 °C aufgebracht wird. Es kann aber auch eine Mischung aus SiH₄ und NO₂ verwendet werden. Die Hilfsschicht 11 kann ebensogut in anderer Weise aufgebrachtes SiO₂ oder Si₃N₄ sein. Unter Verwendung dieser Hilfsschicht 11 wird eine ganzflächige Implantation vorgenommen mit Dotierstoff für den Leitungstyp der herzustellenden Emitterzone. Es wird daher die zuvor umdotierte Emitter-Basis-Zone 90 erneut umdotiert. Der vertikal angeordnete Abschnitt der Hilfsschicht 11 schirmt dabei die Basiszone 9 gegen diese Implantation ab. Die Umdotierung erfolgt daher nur in dem in Fig. 3 eingezeichneten Bereich der Emitterzone 7. Oberhalb dieser Emitterzone 7 besitzt die Hilfsschicht 11 nur die Dicke d1, die von dem Dotierstoff durchdrungen wird. Die Dosis der Implantation muß so groß gewählt werden, daß die zuvor in diesem Bereich implantierte Basisdotierung kompensiert wird und außerdem die Dotierung der Emitterzone 7 so hoch wird, daß sie niederohmig kontaktiert werden kann (Höhe dieser Dotierung z. B. 1 x 10¹⁹ cm⁻³). Ggf. erfolgt unmittelbar nach der Implantation ein Ausheilungs- und/oder Diffusionsschritt (z. B. 10 Sekunden bei 950 °C).

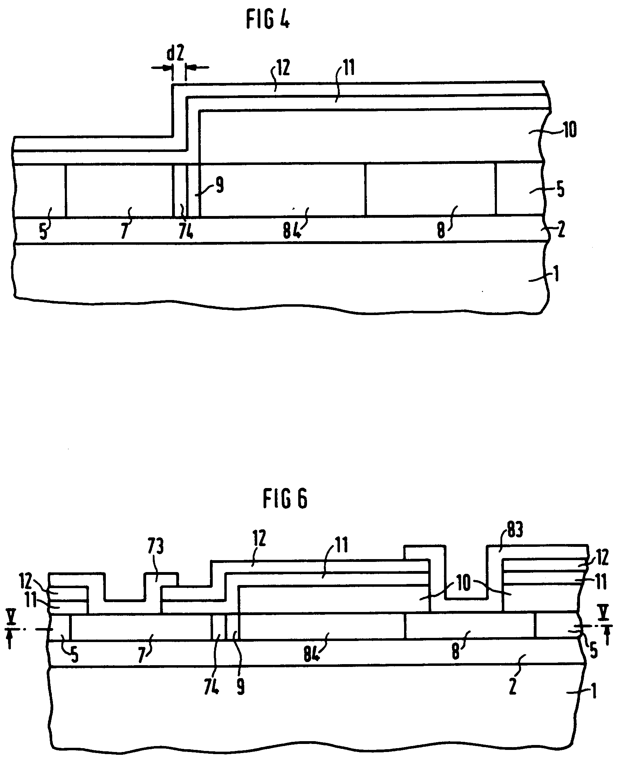

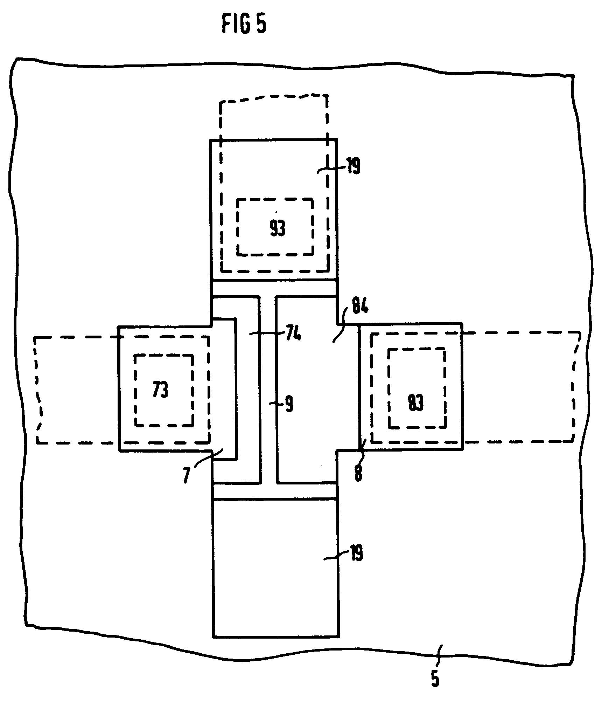

Bei einem Ausführungsbeispiel des erfindungsgemäßen Verfahrens wird eine zweite Hilfsschicht 12 entsprechend Fig. 4 ganzflächig konform abgeschieden. Mit der Dicke d2 dieser zweiten Hilfsschicht 12 wird die Abmessung einer niedrig dotierten weiteren Emitterzone 74 festgelegt. Die unter Verwendung nur der Hilfsschicht 11 vorgenommene Implantation erzeugt dann die Dotierungshöhe, die für diese weitere Emitterzone 74 vorgesehen ist. Die für die Emitterzone 7, die der Kontaktierung dient, vorgesehene hohe Dotierung wird unter Verwendung der zweiten Hilfsschicht 12 eingebracht. Die Zonen werden nach der Implantation jeweils ausgeheilt.

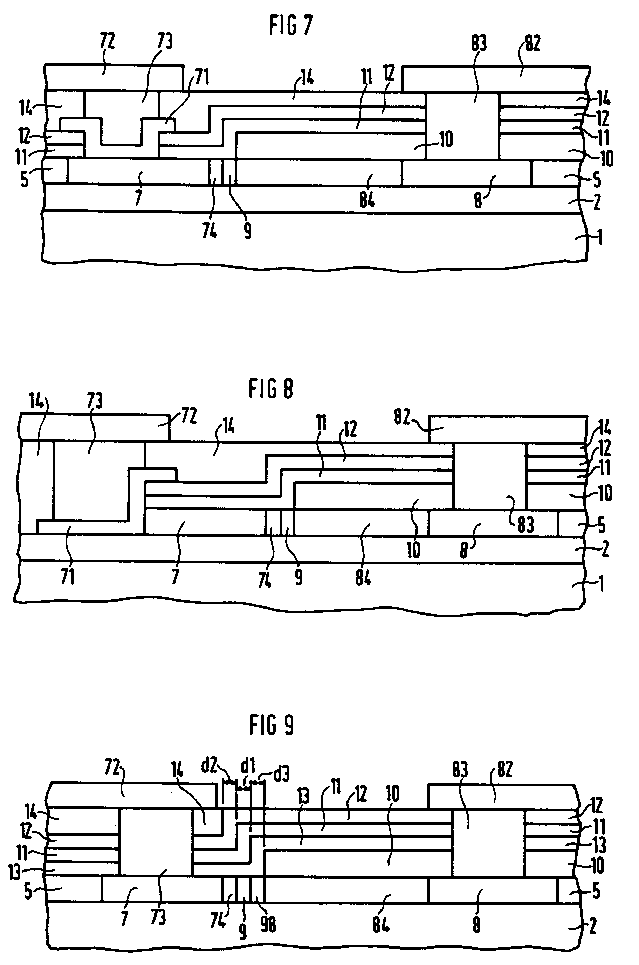

Die Anordnung der Emitterzone 7, der weiteren Emitterzone 74, der Basiszone 9, der Kollektorzone 8, der weiteren Kollektorzone 84 und der Basisanschlußzone 19 sind in Fig. 5 dargestellt. Diese Fig. 5 zeigt den in Fig. 6 eingezeichneten Schnitt auf der Höhe der Siliziumschicht 3. Die Kontakte und Metallisierungen sind in Fig. 5 durch gestrichelte Linien angedeutet. Diese Kontaktierungen werden hergestellt, indem die Hilfsschicht 11, ggf. die zweite Hilfsschicht 12 und die Dielektrikumschicht 10 unter Zuhilfenahme einer Fototechnik strukturiert, d. h. mit Kontaktlöchern versehen werden. Ggf. kann vorher eine weitere Dielektrikumschicht, die als Planarisierungsschicht 14 in den Fig. 7, 8 und 9 eingezeichnet ist, aufgebracht werden, um die Oberfläche zu planarisieren. Die Einebnung der Oberfläche dieser Planarisierungsschicht 14 kann durch Polieren oder Verfließenlassen der erwärmten Schicht erfolgen. Die Metallkontakte 73 für den Emitter und 83 für den Kollektor werden zusammen mit dem Metallkontakt für die Basis in diese Kontaktlöcher aufgebracht. Für diese Metallkontakte kann z. B. eine Metallisierung aus TiN/AlSiCu oder TiN/W/AlSiCu verwendet werden.

Bei dem erfindungsgemäßen Verfahren können Emitter, Basis und Kollektor auch zunächst mit dotiertem Polysilizium und dann erst mit Metall kontaktiert werden. In dem Beispiel der Fig. 7 befindet sich eine Kontaktschicht 71 aus Polysilizium als Beispiel nur auf der Emitterzone 7. Die Planarisierungsschicht 14 ist zunächst ganzflächig vorhanden und wird dann zusammen mit der Hilfsschicht 11, ggf. der zweiten Hilfsschicht 12 und der Dielektrikumschicht 10 im Bereich der Kontaktlöcher entfernt. Diese Kontaktlöcher werden mit den Metallkontakten 73 für den Emitter, 83 für den Kollektor und für die Basis aufgefüllt (Plug-Technik). Die planare Oberfläche wird dann mit Metallisierungen 72 für den Emitteranschluß und 82 für den Kollektoranschluß und einer entsprechenden Metallisierung für den Basisanschluß auf der Oberfläche versehen. Diese Metallisierungsebene kann z. B. durch Leiterbahnen gebildet werden. In diesem Ausführungsbeispiel kann die Kontaktschicht 71 entfallen, wobei dann der Metallkontakt 73 für den Emitter direkt auf der Emitterzone 7 aufgebracht ist, oder eine zweite Kontaktschicht aus Polysilizium zwischen der Kollektorzone 8 und dem Metallkontakt 83 für den Kollektor hergestellt werden. Im Gegensatz zur Ausführungsform der Fig. 6 erhält man damit eine planare Oberfläche.

Bei dem erfindungsgemäßen Verfahren kann, wie eingangs erwähnt, die Isolation der einzelnen Transistoren gegeneinander auch dadurch erfolgen, daß außerhalb der vorgesehenen Transistorbereiche die Siliziumschicht 3 bis zur Isolationsschicht 2 entfernt wird. In diesem Fall ergibt sich die Möglichkeit, die Transistorbereiche auch seitlich anzuschließen. Eine besonders vorteilhafte Ausführungsform dieser Struktur ergibt sich bei Herstellung eines lateralen Polysiliziumemitters. Diese Ausführungsform ist in Fig. 8 dargestellt. Lateral zur Emitterzone 7 ist hier der entsprechende Anteil der Siliziumschicht 3 vollständig entfernt und die Kontaktschicht 71 aus Polysilizium unmittelbar auf der Isolationsschicht 2 derart aufgebracht, daß sie seitlich die Emitterzone 7 kontaktiert. Wie in dem Ausführungsbeispiel der Fig. 7 befindet sich auf dieser Kontaktschicht 71 der Metallkontakt 73 für den Emitter, der wieder mittels Plug-Technik in einem Kontaktloch der Planarisierungsschicht 14 hergestellt und auf der Oberseite mit einer Metallisierung 72 für den Emitteranschluß versehen wurde. Auf der Kollektorseite ist bei diesem Ausführungsbeispiel auch die Anschlußvariante ohne gesonderte Kontaktschicht aus Polysilizium gezeichnet. Auch auf der Kollektorseite kann eine solche Polysiliziumschicht zwischen der Kollektorzone 8 und dem Metallkontakt 83 für den Kollektor hergestellt werden. Auch auf der Kollektorseite kann der Isolationsbereich 5 entfernt sein und die Kontaktschicht lateral zur Kollektorzone 8 auf der Isolationsschicht 2 aufgebracht sein. Als Alternative zu dem Beispiel der Fig. 8 kann die Kontaktschicht 71 die Emitterzone 7 lateral und auf der Oberseite kontaktieren. Die Hilfsschicht 11 und ggf. die zweite Hilfsschicht 12 sind dann in dem Bereich auf der Oberseite der Emitterzone 7 entfernt und die Kontaktschicht 71 aus Polysilizium entsprechend lateral und auf dieser freien Oberseite der Emitterzone 7 aufgebracht. Der Metallkontakt 73 für den Emitter kann dann auf dem über der Emitterzone 7 vorhandenen Anteil der Polysiliziumschicht aufgebracht sein. Die Tiefe des Kontaktloches ist dann entsprechend um die Höhe der Emitterzone 7 geringer. Wie bereits erwähnt, kann die zweite Hilfsschicht 12 in allen diesen Ausführungsvarianten weggelassen werden. Die Emitterzone 7 grenzt dann unmittelbar an die Basiszone 9 an. Bei dem entsprechenden Implantationsschritt für die Emitterzone 7 ist die Dosis der Dotierung dann entsprechend zu erhöhen, um eine niederohmige Kontaktierung der Emitterzone 7 zu ermöglichen.

Bei dem erfindungsgemäßen Verfahren kann sowohl zwischen der Basiszone 9 und der hoch dotierten Emitterzone 7 als auch zwischen der Basiszone 9 und der als aktive Kollektorzone vorgesehenen weiteren Kollektorzone 84 eine Zone geringerer Dotierung hergestellt werden. Dazu wird eine weitere Hilfsschicht benötigt. Die niedriger dotierte Zone zwischen Basiszone 9 und Emitterzone 7 wird durch die weitere Emitterzone 74, die wie beschrieben hergestellt werden kann, gebildet. Eine niedriger dotierte Zone mit dem Vorzeichen der Leitfähigkeit der Basiszone 9 oder mit dem Vorzeichen der Leitfähigkeit der Kollektorzone 8 und angeordnet zwischen dieser Basiszone 9 und der als aktive Kollektorzone vorgesehenen weiteren Kollektorzone 84 wird unter Verwendung dieser weiteren Hilfsschicht als primärer Hilfsschicht hergestellt. Nach dar Strukturierung der Dielektrikumschicht 10 wird der von dieser Dielektrikumschicht 10 frei gelassene Anteil des Bereiches 4 mit Grunddotierung zunächst umdotiert. Dabei wird die Höhe der Dotierung so gewählt, wie sie für die weitere niedrig dotierte Zone, die an die weitere Kollektorzone 84 angrenzt, vorgesehen ist. Bei unvollständiger Umdotierung erhält die herzustellende weitere Basiszone den Leitfähigkeitstyp der Grunddotierung bei geringerer Dotierungshöhe (Dichte der Akzeptoren bzw. Donatoren). Bei vollständiger Umdotierung erhält die herzustellende weitere Basiszone denselben Leitfähigkeitstyp wie die eigentliche Basiszone 9, aber mit geringerer Dotierungshöhe. Unter Verwendung der primären Hilfsschicht 13 der Dicke d3, die diese weitere Basiszone 98 (s. Fig. 9) abschirmt, wird dann die Dotierung für die Basiszone 9 implantiert. Im Anschluß daran kann mit der Hilfsschicht 11 und der zweiten Hilfsschicht 12 wie beschrieben weiter verfahren werden. Auf diese Weise erhält man die Struktur der Fig. 9, bei der im Beispiel eines npn-Transistors die Leitfähigkeitstypen wie folgt sind:
Emitterzone 7 n⁺, weitere Emitterzone 74 n⁻, Basiszone 9 p, weitere Basiszone 98 p⁻ oder n⁻, weitere Kollektorzone 84 n und Kollektorzone 8 n⁺. Für die Kontaktierung hat man in diesem Ausführungsbeispiel dieselben Möglichkeiten wie zuvor beschrieben wurde.

Bei den beschriebenen Versionen ist die Basis jeweils seitlich herausgezogen, d. h. die Basiszone 9 verläuft streifenförmig senkrecht zur Zeichenebene der Figuren, und endet in einer hoch dotierten Basisanschlußzone 19 (s. Fig. 5), die als Basisanschluß dient und entsprechend kontaktiert wird. Diese Kontaktierung selbst kann direkt durch Metall oder indirekt über eine Kontaktschicht aus Polysilizium erfolgen.

Durch die Verwendung der Hilfsschicht 11, die durch die strukturierte Dielektrikumschicht 10 einen abschirmenden vertikalen Anteil erhält, kann die Basiszone 9 sehr genau mit geringer lateraler Abmessung hergestellt werden. Die vertikale Abmessung des erfindungsgemäß hergestellten Transistors ergibt sich automatisch durch die verwendete Dicke der ursprünglichen Siliziumschicht 3 des SOI-Substrates.

## Patentansprüche

1. Verfahren zur Herstellung eines lateralen Bipolartransistors, bei dem
in einem ersten Schritt in einer Siliziumschicht (3), die sich auf einer Isolationsschicht (2) befindet, ein für einen Transistor vorgesehener Bereich (4) lateral ringsum elektrisch isoliert wird und dieser Bereich (4) mit einer Grunddotierung versehen wird,
in einem zweiten Schritt unter Verwendung von Masken (6) eine hoch dotierte Basisanschlußzone (19) und eine hoch dotierte Kollektorzone (8) durch Implantation von Dotierstoffen hergestellt werden,
in einem dritten Schritt eine strukturierte Dielektrikumschicht (10), die diese Basisanschlußzone (19) und einen für den Kollektor vorgesehenen Bereich abdeckt und die einen für die Basis und den Emitter vorgesehenen Bereich frei läßt und die an der Grenze zwischen dem abgedeckten Bereich und dem frei gelassenen Bereich eine bezüglich der Schichtebene senkrechte Flanke hat, in einer für den nachfolgenden sechsten Schritt ausreichenden Dicke aufgebracht wird,
in einem vierten Schritt unter Verwendung dieser Dielektrikumschicht (10) als Maske eine Implantierung von Dotierstoff für den Leitungstyp der Basis vorgenommen wird,
in einem fünften Schritt eine Hilfsschicht (11) in einer Dicke (d1), die der in Richtung von Emitter zu Kollektor gemessenen Länge einer herzustellenden Basiszone (9) entspricht, ganzflächig isotrop aufgebracht wird,
in einem sechsten Schritt unter Verwendung dieser Hilfsschicht (11) als Abschirmung für diese Basiszone (9) eine Implantation von Dotierstoff für den Leitfähigkeitstyp einer Emitterzone (7) vorgenommen wird,
in einem siebten Schritt Kontaktlöcher für den elektrischen Anschluß dieser Emitterzone (7), der Basisanschlußzone (19) und der Kollektorzone (8) hergestellt werden und
in einem achten Schritt Metallkontakte (73, 83, 93) für Emitter, Kollektor und Basis aufgebracht werden.

2. Verfahren nach Anspruch 1, bei dem
in dem sechsten Schritt die Höhe der Dotierung für eine herzustellende weitere Emitterzone (74) zwischen einer hoch dotierten Emitterzone (7) und der Basiszone (9) eingestellt wird,
zwischen dem sechsten und dem siebten Schritt eine zweite Hilfsschicht (12) in einer Dicke (d2), die der in Richtung von Emitter zu Kollektor gemessenen Länge dieser weiteren Emitterzone (74) entspricht, ganzflächig isotrop aufgebracht wird, dann
vor dem siebten Schritt unter Verwendung dieser zweiten Hilfsschicht (12) als Abschirmung für diese weitere Emitterzone (74) eine Implantierung von Dotierstoff für diese hoch dotierte Emitterzone (7) vorgenommen wird und
in dem siebten Schritt ein Kontaktloch für den Anschluß dieser hoch dotierten Emitterzone (7) hergestellt wird.

3. Verfahren nach Anspruch 1 oder 2, bei dem
in dem vierten Schritt die Höhe der Dotierung für eine herzustellende weitere Basiszone (98) zwischen einer hoch dotierten Basiszone (9) und der Kollektorzone (8) eingestellt wird, zwischen dem vierten und dem fünften Schritt eine primäre Hilfsschicht (13) in einer Dicke (d3), die der in Richtung von Emitter zu Kollektor gemessenen Länge dieser weiteren Basiszone (98) entspricht, ganzflächig isotrop aufgebracht wird, und dann
vor dem fünften Schritt unter Verwendung dieser primären Hilfsschicht (13) als Abschirmung für diese weitere Basiszone (98) eine Implantierung von Dotierstoff für diese hoch dotierte Basiszone (9) vorgenommen wird.

4. Verfahren nach einem der Ansprüche 1 bis 3, bei dem in dem ersten Schritt die Grunddotierung für den Leitungstyp des Kollektors hergestellt wird und
in dem dritten Schritt die Dielektrikumschicht (10) so aufgebracht wird, daß ein mit dieser Grunddotierung versehener Bereich, der als weitere Kollektorzone (84) vorgesehen ist und sich zwischen der hoch dotierten Kollektorzone (8) und der herzustellenden Basiszone (9) befindet, von dieser Dielektrikumschicht (10) bedeckt wird.

5. Verfahren nach einem der Ansprüche 1 bis 4, bei dem vor dem siebten Schritt eine Planarisierungsschicht (14) aus Dielektrikum zum Einebnen der Oberfläche aufgebracht wird.

6. Verfahren nach einem der Ansprüche 1 bis 5, bei dem nach dem sechsten Schritt die Emitterzone (7) in einem für elektrischen Anschluß vorgesehenen Bereich freigelegt wird und eine Kontaktschicht (71) aus Polysilizium darauf aufgebracht wird.

7. Verfahren nach Anspruch 6, bei dem dieser Bereich, in dem die Emitterzone (7) freigelegt ist, zumindest eine laterale Begrenzung der Emitterzone (7) umfaßt und diese Kontaktschicht (71) so aufgebracht wird, daß sie zumindest in dieser freigelegten lateralen Begrenzung der Emitterzone (7) an die Emitterzone (7) angrenzt.

8. Verfahren nach einem der Ansprüche 1 bis 7, bei dem für die Herstellung der Hilfsschicht (11) Tetraethylorthosilan (TEOS) verwendet wird.

9. Verfahren nach einem der Ansprüche 1 bis 8, bei dem für den ersten Schritt ein SOI-Substrat (1, 2, 3) verwendet wird.
